Europäisches Patentamt

(19) European Patent Office

Office européen des brevets

(11) Publication number: **0 225 704**
A2

## (12) EUROPEAN PATENT APPLICATION

(21) Application number: **86308184.0**

(22) Date of filing: **21.10.86**

(51) Int. Cl.⁴: **G 01 R 13/32**, G 01 R 13/34

(30) Priority: **02.12.85 US 803187**

(43) Date of publication of application: **16.06.87** Bulletin **87/25**

(84) Designated Contracting States: **DE FR GB NL**

(71) Applicant: **TEKTRONIX, INC., Tektronix Industrial Park D/S Y3-121 4900 S.W. Griffith Drive P.O. Box 500, Beaverton Oregon 97077 (US)**

(72) Inventor: **Carlton, Dale E., 5465 N.W. Pondosa, Portland Oregon 97229 (US)**

(74) Representative: **Burke, Steven David et al, R.G.C. Jenkins & Co. 12-15, Fetter Lane, London EC4A 1PL (GB)**

(54) **Method and apparatus for waveform analysis.**

(57) Information regarding a statistical property of a wave is collected by electronically sampling the wave at a first sample point within a waveform epoch and measuring the magnitude of the wave at that sample point relative to a datum magnitude. Respective bands within a range of magnitudes are allocated to a plurality of addressable locations in an electronic memory device, and the contents of the addressable location to which is allocated the band of magnitudes in which the measured magnitude of the wave at the first sample point lies, is incremented by one unit. These steps are repeated for a plurality of additional sample points in a waveform epoch, the sample points being incoherent relative to the wave.

1

## METHOD AND APPARATUS FOR WAVEFORM ANALYSIS

This invention relates to a method and apparatus for waveform analysis.

### Background of the Invention

A measuring tool that is commonly used in waveform analysis is the oscilloscope, which provides a visual representation of a wave. A conventional real time oscilloscope provides a continuous but ephemeral representation of a wave. On the other hand, a digital storage oscilloscope, which samples the wave at a uniform frequency and writes the sampled magnitudes into memory, can provide a more enduring display of the wave by reading the stored magnitude values from memory, converting the stored magnitude values to analog form and using the resulting analog signal to drive the vertical deflection amplifier of the oscilloscope. Time information, for driving the horizontal deflection amplifier, is derived from the clock signals used for reading the magnitude information from memory. By carrying out appropriate operations on the data stored in the memory of the oscilloscope, various attributes of the waveform, such as its base magnitude and top magnitude (see IEEE Standard, Pulse Terms and Definitions, IEEE Std. 194- 1977, IEEE, New York, 1977), can be determined with a greater accuracy than is normally possible by carrying out measurements on the displayed waveform of a real time oscilloscope.

In A. A. Guido et al, "Automatic Pulse Parameter Determination with the Computer Augmented Oscilloscope System", IBM J. Res. Develop, 204 (1971), there is described a system in which values of pulse parameters are determined using a sampling oscilloscope in conjunction with a computer. H. Moriyasu et al, "Digital Processing Interface Brings Computer Power to Oscilliscope", Electronics, March 15, 1973, 98, and U.S. Patent No. 4,225,940 issued September 30, 1980 to H. Moriyasu et al describe the Tektronix Digital Processing Oscilloscope, which allows a repetitive wave to be sampled on consecutive repetition to build up an ensemble of magnitude values. These magnitude values can be used to provide a representation of the wave. In addition, mathematical analysis can be carried out on the magnitude values, e. g. to calculate the Fourier transform of the wave.

In the conventional digital storage oscilloscope, the wave is sampled at uniform intervals and sample values are written into consecutive locations in memory. Therefore, in order to resolve a wave into n samples, it is necessary that n separately addressable memory locations should be available for receiving the n sample values respectively. If it is desired to sample a repetitive wave on successive repetitions, for example in order to carry out noise reduction by averaging, it is generally necessary that n addressable locations be available for each repetition that is sampled.

## Summary of the Invention

A preferred embodiment of the present invention comprises a random access memory device having a plurality of separately addressable locations. A sampling device is employed to sample a wave in incoherent fashion at a plurality of sample points within a waveform epoch. The magnitude of the wave at each sample point is converted into an address for the memory device, each possible address being allocated to a band of magnitudes of the wave. The contents of the memory device at each addressable location are incremented by one unit for each sample point for which the magnitude of the wave lies in the band of magnitudes allocated to the address of that location.

## Brief Description of the Drawings

For a better understanding of the invention, and to show how the same may be carried into effect, reference will now be made, by way of example, to the accompanying drawings in which:

FIG. 1 is a block diagram of waveform analysis apparatus embodying the present invention,

FIGS. 2A and 2B illustrate respectively one cycle of a repetitive waveform and a histogram representing the distribution of magnitudes within a sampling interval that is equal to the period of the waveform,

FIG. 3A illustrates a portion of the waveform of FIG. 2A at an enlarged scale, and

FIG. 3B is a histogram representing the distribution of magnitudes over the portion of the waveform shown in FIG. 3A.

## Detailed Description

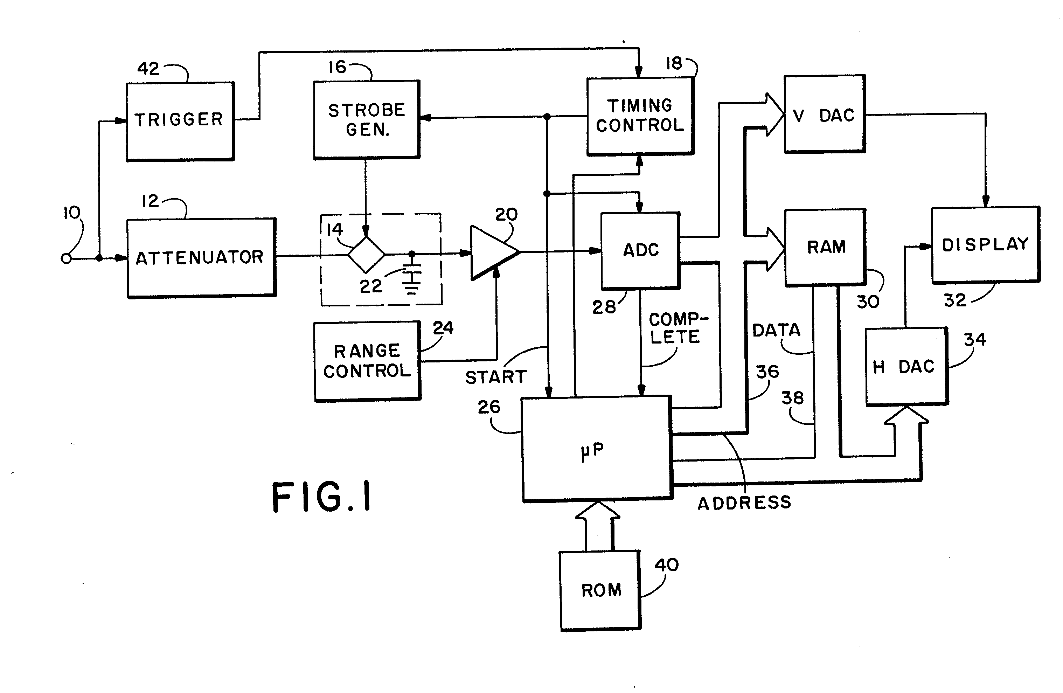

The apparatus shown in Fig. 1 comprises an attenuator 12 to which a repetitive analog input signal is applied by way of an input terminal 10. The attenuated input signal is applied to a sampling gate 14. The sampling gate may be of conventional form, comprising four diodes arranged in a bridge and actuated by brief strobe pulses. The strobe pulses are provided by a strobe generator 16 in response to timing control pulses provided by a timing control circuit 18.  The circuit 18 provides pulses to the strobe generator 16 to determine the instant at which the strobe generator actuates the sampling gate.

The timing control circuit 18 operates under control of a trigger circuit 42 and a microprocessor 26.  The trigger circuit 42 provides a trigger pulse to the timing control circuit when the voltage of the input signal passes through a preselected trigger level, in the manner of the trigger circuit of a conventional oscilloscope.  The microprocessor 26 provides a control signal that indicates the proportion of the period of the input signal over which samples are to be taken, the delay between the trigger pulse and the start of the interval over which samples are to be taken, and the number of samples that are to be taken. The information provided by the microprocessor thus establishes an equivalent time sampling interval. For a given measurement, the sampling interval has a fixed start time and a fixed stop time relative to the trigger point.  If the sampling interval is one period of the input signal, the start time for one cycle of the input signal coincides with the stop time for the next cycle.  The timing control circuit 18 generates one timing control pulse during each cycle of the input signal, the occurrences of the timing control pulses on successive cycles being distributed at random over the interval between the start time and the stop time.

When the sampling gate is actuated, the attenuated input signal is applied to a capacitor 22, and the capacitor is charged to a voltage that depends on the voltage of the attenuated input signal during the brief interval for which the sampling gate was actuated. The capacitor 22 is also connected to a variable gain amplifier 20 which receives a gain control signal from a range controller 24. The range controller 24 also provides an offset signal to the capacitor 22. The gain control signal and the offset signal are generated in a manner and for a purpose that will be explained hereinafter.

The amplifier 20 has a high input impedance, and therefore its output voltage accurately represents the voltage of the attenuated input signal during the sample interval. The output terminal of the amplifier 20 is connected to an analog-to-digital converter (ADC) 28. The timing control circuit 18 provides a "start" signal to the ADC 28. The "start" signal determines the time at which the ADC starts converting the analog output voltage provided by the amplifier 20 into digital form. This time is delayed somewhat relative to the time at which the corresponding strobe pulse is generated, in order to allow the output voltage of the amplifier 20 to settle. The ADC 28 provides at its output a succession of eight bit parallel digital words. Each word (other than the most significant word or MSW and the least significant word or LSW) represents a limited band of values for the output voltage of the amplifier 20. The MSW (11111111) represents a range of values that is open at the upper end, whereas the LSW (00000000) represents a range of values that is open at the lower end.

A random access memory (RAM) 30 having at least 256 addressable locations has an address bus 36 and a data bus 38. Both buses are connected to a microprocessor 26, and the eight bit parallel output of the ADC 28 also is connected to the address bus 36.

The "start" signal that is generated by the timing control circuit 18 and is applied to the ADC 28 is also applied to the microprocessor 26, and the microprocessor responds by preparing to receive data, e. g. by clearing registers. When the ADC has completed a conversion cycle, and provides at its output a digital word which represents the magnitude of the analog voltage applied to the input of the ADC when the "start" signal was received, the ADC generates a "complete" signal, and this signal is applied to the microprocessor. When the microprocessor 26 receives the "complete" signal from the ADC 28, it enters an increment routine. The microprocessor writes the digital word that is applied to the address bus 36 by the ADC into an internal register. The microprocessor 26 applies this digital word to the address bus 36, and applies a read enable pulse to the memory 30 over a control line (not shown). The memory 30 places the contents of the addressable location defined by the address word on the data bus 38. The microprocessor writes the digital word placed on the data bus into a second internal register, increments the contents of the second register by one, and writes the resulting digital word back into the same location in the memory 30. This increment routine is repeated until a statistically significant volume of data has been collected.

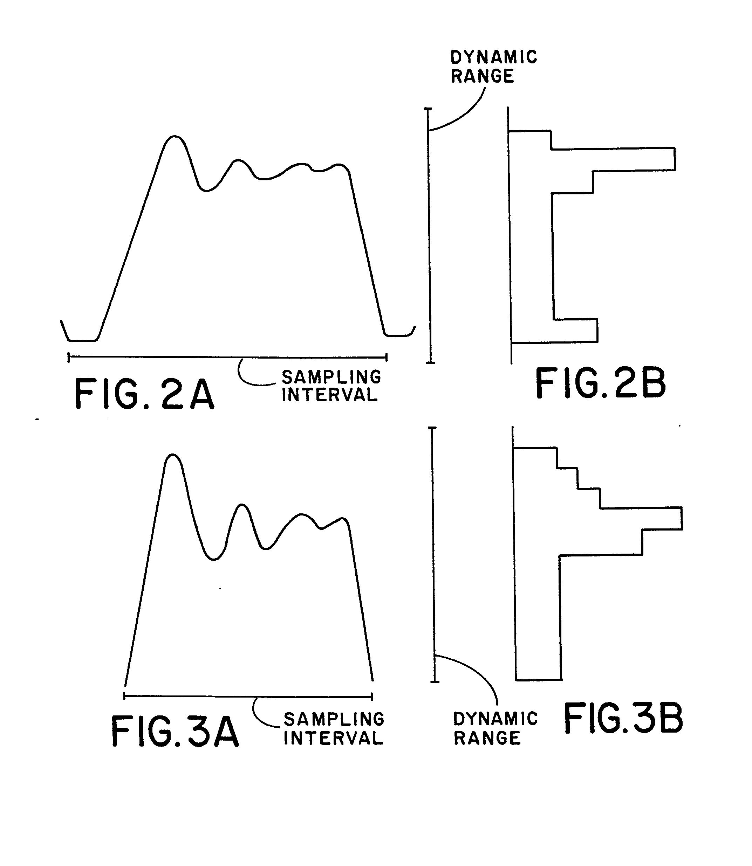

The apparatus performs three distinct operations, namely an initial set-up operation, a data collection operation and a data analyzing operation. If, for example, it is desired that a histogram representing the occurrence density distribution of magnitude values of the wave during a complete cycle of the input signal be generated, then in the set-up operation gain control and offset signals are applied to the amplifier 20 and the capacitor 22 so as to adjust the peak-to-peak magnitude of the wave and the DC level of the wave so that all the analog voltage levels applied to the input of the ADC 28 are within the dynamic range of the ADC. This may be achieved by the user of the apparatus, by observing the waveform on a conventional oscilloscope and measuring the peak-to-peak amplitude of the waveform and its offset from a reference level and manually causing appropriate offset and gain control signals to be applied to the capacitor 22 and the amplifier 20 respectively, so as to bring the range of output voltages of the amplifier 20 into the dynamic range of the ADC 28. However, it is preferred that the offset and gain control signals be generated automatically by the range control circuit 24 under control of the microprocessor 26. By executing an algorithm using the contents of the memory 30, e. g. determining whether there are any occurrences of 11111111 and 00000000 and determining the values of the MSW and LSW that are actually provided by the ADC 28, the microprocessor can cause the range control circuit to generate appropriate gain control and offset signals to bring the range of output voltages of the amplifier 20 within the dynamic range of the ADC 28 and make it only slightly smaller than the dynamic range of the ADC. In order to generate a histogram, it is preferred that the gain control and offset signals that are generated be such that, for a complete cycle of the input signal, the ADC 28 produces no occurrences of the word 00000000 or 11111111, and at least one occurrence of the words 00000001 and 11111110, since this implies that the dynamic range of the ADC 28 is fully used without there being any samples that lie in the two openended ranges associated with the LSW and the MSW of the DAC 28. An appropriate algorithm might involve a binary search technique or repeatedly and alternately adjusting the gain and the offset. In the event that the attenuator 12 has digitally selectable attenuation ratios, the range control circuit may act on the attenuator 12 instead of on the amplifier 20. FIGS. 2A and 2B illustrates respect-ively the waveform of an input signal and the corresponding histogram.

When the set-up operation has been completed, the contents of the memory 30 are cleared and the data collection operation is commenced. In the data collection operation, the digital signal provided by the ADC 28 is used to increment the contents of the memory 30 a statistically significant number of times. In a test carried out using an embodiment of the invention, 65,000 samples were taken in order to represent the distribution of occurrences of each of 256 magnitude values over a sampling interval of 20 ns. It will be appreciated that this is essentially the same operation that is carried out in order to accumulate the data necessary for adjusting the offset and gain control signals. However, the number of samples taken in the data collection operation would normally be higher. At the end of the data collection operation, the contents of the memory 30 represent the occurrence density distribution of magnitude values falling within the different bands represented by the successive quantization levels of the ADC.

Programs for controlling the operation of the microprocessor 26 during adjustment of the offset and gain control signals and during incrementing of the contents of the addressable locations in the memory 30 are stored in a read only memory (ROM) 40. The ROM 40 also contains programs that are used during the data analysis operation for manipulating the information stored in the memory 30. For example, the ROM may contain a program for generating a histogram display on a display device 32, such as a cathode-ray tube, by clocking the stored digital data out of the memory 30, converting the digital data to analog form by means of a digital-to-analog converter 34, and applying the analog signal to the horizontal deflection circuit of the display device 32 while the addresses of the respective locations are used to generate an analog signal that is applied to the vertical deflection circuit. Other programs may be used to determine the duty cycle, the base magnitude, the top magnitude, the pulse amplitude, and any desired percent reference magnitude, such as the 50% reference magnitude at which the mesial line lies or the 10% reference magnitude at which the proximal line lies.

Instead of operating on the entire range of output voltages of the amplifier 20, it may be desired to examine a smaller range of output voltages at higher resolution. This may be achieved by executing a different algorithm during the set-up operation. For example, in order to determine the top magnitude with increased accuracy, the microprocessor might reduce the duration of the sampling interval (taking account of the duty cycle) and adjust the offset and gain control signals and the

10

position of the sampling interval relative to the trigger point so that there are no occurrences of 11111111, at least one occurrence of 11111110, at least two occurrences of 00000000, exactly two occurrences of each word other than 00000000 in, say, the bottom third of the dynamic range of the ADC, and more than two occurrences of the majority of words in, say, the middle third of the dynamic range of the ADC (FIG. 3A). The corresponding histogram is shown in FIG. 3B.

It will be appreciated that certain features of the apparatus, such as signal lines for controlling access to the memories 30 and 40, though important to operation of the apparatus, are not necessary to an understanding of the invention and have not been shown in the drawing because a person of ordinary skill in the art would understand that such features are necessary and would be well able to provide them.

It will also be appreciated that the present invention is not restricted to the particular apparatus and method that have been described, and the variations may be made therein without departing from the scope of the invention as defined in the appended claims, and equivalents thereof. For example, although the timing control circuit 18 generates timing control pulses that are distributed at random over the interval between the start time and the stop time, incoherent sampling could also be obtained by sampling periodically, provided that the equivalent frequency of sampling is not equal to the frequency of a component of the input signal, or of a sub-harmonic of a component of the input signal. However, in the case of a broadband input signal, it is very difficult to achieve incoherence in this manner and therefore random sampling is preferred.

## Claims

1. A method of collecting information regarding a statistical property of a wave, comprising

(a) allocating respective bands within a range of magnitudes to a plurality of addressable locations in an electronic memory device,

(b) electronically sampling the wave at a first sample point within a waveform epoch,

(c) measuring the magnitude of the wave at said sample point relative to a datum magnitude,

(d) incrementing by one unit the contents of the addressable location to which is allocated the band of magnitudes in which the measured magnitude of the wave at the first sample point lies, and

(e) repeating steps (b), (c) and (d) for a plurality of additional sample points in the waveform epoch, the sample points being incoherent relative to said wave.

2. Apparatus for collecting information regarding a statistical property of a wave, comprising a random access memory device having a plurality of separately addressable locations, a sampling device for sampling a wave in incoherent fashion at a plurality of sample points within a waveform epoch, quantizing means for converting the magnitude of the wave at each sample point into an address for the memory device, each possible address being allocated to a band of magnitudes of the wave, and control means for causing the contents of the memory device at each addressable location to be incremented by one unit for each

0225704

13

sample point for which the magnitude of the wave lies in the band of magnitudes allocated to the address of that location.

3. Apparatus according claim 2, wherein the quantizing means have a limited dynamic range, and the control means comprise means for bringing a selected range of values of the magnitude of the wave within the dynamic range of the quantizing means.

FIG.1

2/2

0225704

FIG. 2A

SAMPLING INTERVAL

DYNAMIC RANGE

FIG.2B

FIG.3A

SAMPLING INTERVAL

DYNAMIC RANGE

FIG.3B